# DEMANDE DE BREVET EUROPEEN

(11) **EP 1 233 494 A1**
(43) Date de publication de la demande: **21.08.2002**
(21) Numéro de dépôt: 02290247.2
(22) Date de dépôt: 04.02.2002
(51) Int. Cl.: H01S 5/227

(54) **Laser semi conducteur a ruban enterré et procédé de fabrication**

(30) Priorité: 13.02.2001 FR 0101912
(71) Demandeur: ALCATEL, 75008 Paris (FR)
(72) Inventeur: Bouadma, Noureddine, 75013 Paris (FR)
(74) Mandataire: Fournier, Michel

(57) **Abrégé**

Pour la fabrication d'un laser à ruban (4) enterré on forme sur une couche dopée p, une fine couche (17) dopée n immédiatement adjacente à une couche (4) active. Après gravure de la couche active pour former le ruban (4), on enterre le ruban (4) dans une couche (19) dopée n en sorte que les quatre faces latérales (41-44) du ruban se trouvent toutes au contact d'une couche (17, 19) dopée n, une face (41) au contact de la fine couche (17) et les trois autres (42-44) au contact de la couche (19) d'enterrement. On améliore ainsi le confinement électrique du ruban (4).

## Description

### Domaine technique

L'invention se situe dans le domaine des lasers semi conducteur à ruban enterré, en particulier ceux utilisés dans le domaine des télécommunications optiques.

### Arrière plan technologique

Des exemples connus de structure laser à ruban enterré sont décrits en page 60 d'un article de J.C. BOULEY intitulé "Evolution et perspectives des structures laser pour télécommunications" paru dans le journal "l'Echo des recherches n° 130, 4ème trimestre 1987". Comme décrit dans la partie supérieure de la page 60 de cet article, la partie active d'un laser à ruban est formée par un ruban de section droite rectangulaire ayant une composition par exemple GaInAsP dont les proportions de chacun des constituants sont une fonction de la longueur d'onde d'émission souhaitée pour le laser. Le ruban est enterré c'est à dire qu'il est entièrement entouré par un milieu d'indice de réfraction plus faible, par exemple InP. Une face du ruban, par exemple la face inférieure est au contact d'une couche d'InP dopé n et les trois autres faces latérales sont au contact d'une couche d'InP dopé p. L'enterrement du ruban actif dans le milieu InP l'entourant complètement a une double utilité. Il permet d'une part de confiner les porteurs injectés dans le ruban, par la présence de la jonction p-n, du fait de la différence de largeur de bande interdite E_{g} entre InP et GaInAsP, par exemple E_{g} = 0,35 eV pour une bande active à 1,3 µm. Il permet d'autre part d'obtenir un guidage bidirectionnel de la lumière en raison de la forte différence d'indice de réfraction n existant entre InP et GaInAsP. Grâce aux faibles dimensions de sa section (largeur∼1,5 µm, épaisseur 0,15µm) le guide d'onde formé par la couche active n'accepte qu'un seul mode de propagation, le mode fondamental, de taille sensiblement équivalente aux dimensions du guide. L'intérêt connu de cette configuration géométrique est d'obtenir des lasers à très faible courant de seuil, car le recouvrement et donc l'interaction entre le mode fondamental et le volume de matériau excité par injection de porteurs devient optimal. L'oscillation laser est alors obtenue par formation d'une cavité de Fabry-Pérot formée, par clivage de faces transversales du ruban.

Les différentes variantes de structures laser à ruban enterré se distinguent les unes des autres par les méthodes utilisées pour injecter et confiner les électrons dans le ruban enterré, ainsi que par les technologies mises en oeuvre.

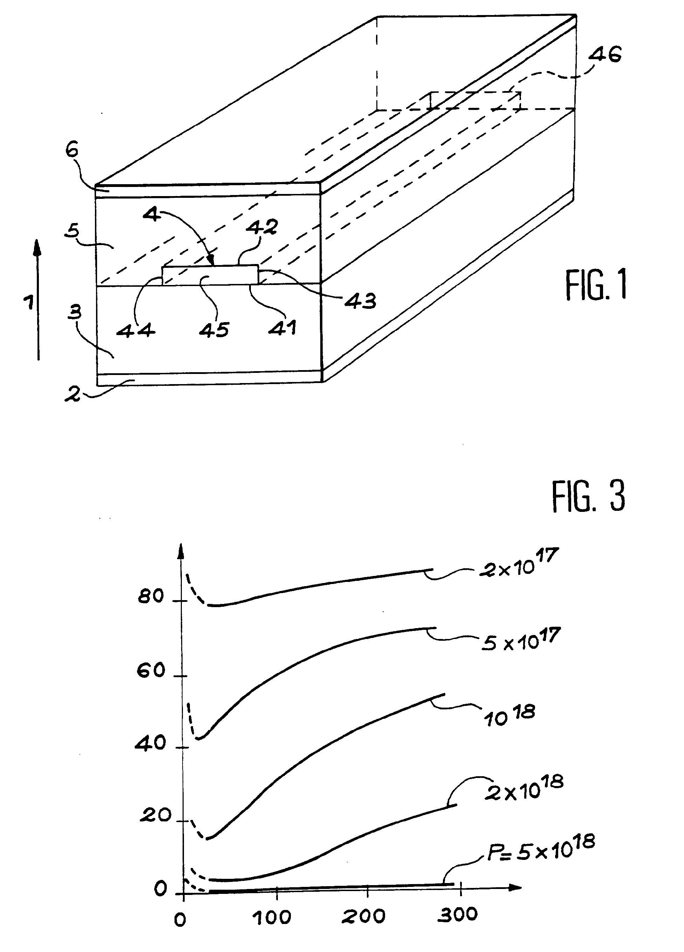

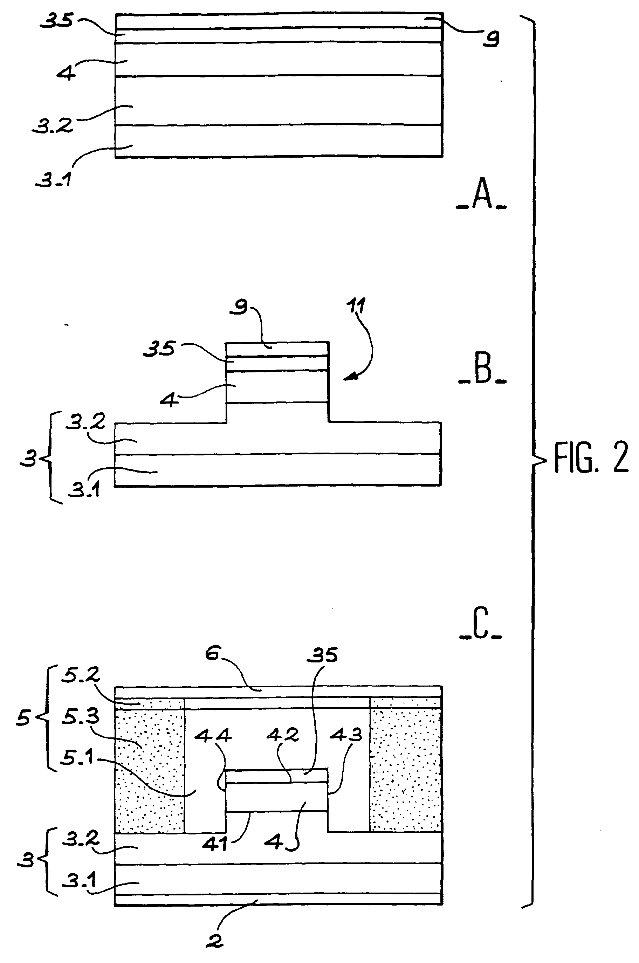

Un schéma de principe d'une structure laser à ruban enterré et de sa fabrication seront décrits ci-après en relation avec les figures 1 et 2 des dessins annexés. La structure comporte dans une direction indiquée par la flèche 1 figure 1 :
- une couche 2 de contact électrique par exemple en TiAu ou autre alliage métallique,
- une couche 3 de InP dopé n,
- déposé sur cette couche le ruban 4 en matériau actif laser par exemple en GaInAsP dont la composition détermine la longueur d'onde obtenue ; ce ruban à 6 faces, une face 41 représentée comme inférieure figure 1 qui est au contact de la couche 3, une face supérieure 42 parallèle à la face 41 et deux faces 43, 44 parallèles entre elles et perpendiculaires aux faces 41, 42 ; enfin des faces clivées transversales 45, 46,
- une couche 5 de InP dopé p ; cette couche 5 est au contact du ruban 4 sur trois faces 42-44 de ce ruban, la face inférieure 41 étant elle au contact de la couche 3 en InP dopée n ;
- enfin une couche 6 de contact par exemple en AuPt.

Un mode de réalisation et des informations complémentaires sur de telles structures enterrées sont décrits ci-après en liaison avec la figure 2.

Cette figure comporte les parties A, B, C représentant chacune une coupe transversale du produit obtenu à différentes étapes de la fabrication.

Sur un substrat 3-1 en InP fortement dopé n par exemple avec une concentration de l'ordre de 5.10¹⁸, on fait croître par épitaxie une couche tampon (buffer) 3-2 en InP dopé n ayant un dopage approprié. Cette couche a en raison de son mode de croissance des qualités cristallines mieux contrôlées que celles de la couche 3-1.

Toujours par épitaxie on fait croître ensuite la couche active 4 en InGaAsP puis une couche 35 en InP de protection de la couche active 4. On dépose ensuite une couche 9 qui est un masque diélectrique, par exemple en SiO₂, protégeant la couche active 4 au cours des étapes suivantes de fabrication.

Le produit obtenu à la fin de cette première étape est représenté figure 2 partie A.

Une gravure profonde est ensuite réalisée. Cette gravure forme un mésa 11 qui émerge au dessus d'une partie épargnée de la couche 3-2. La largeur du mésa 11 est la largeur du ruban 4. Le mésa 11 comporte de sa partie supérieure à sa partie inférieure ce qui reste après gravure des couches 9, 35, 4, et d'une partie de l'épaisseur de la couche 3-2 située de part et d'autre du mésa 11.

Le produit obtenu en fin de gravure profonde est représenté figure 2, partie B. Sur les parties B et C de la figure 2 les faces 43, 44 ont été représentées perpendiculaires aux plans des couches par exemple 3 et 4. Il faut cependant comprendre que du fait du mode de gravure ces faces ne sont pas des plans. Il en résulte que les angles formés par des plans tangents aux faces 43, 44 respectivement et un plan parallèle aux couches ont des valeurs qui peuvent être différentes les unes des autres.

On procède ensuite, après retrait du masque 9, à une reprise de croissance épitaxiale pour former tout autour de la partie dégagée du ruban 4, la couche 5 en InP dopé p. Le ruban 4 a ainsi ses faces latérales 42, 43, et 44 directement adjacentes à un matériau InP dopé p, réalisant ainsi l'effet de confinement optique en raison de la différence d'indice optique entre le matériau constituant la couche 4 et le matériau des couches adjacentes et le confinement électrique du ruban 4 en raison de la jonction n-p entre les couches 3 et 5. La couche 5 est réalisée en 2 parties superposées 5-1 et 5-2. La couche 5-1 est située immédiatement au-dessus des couches 3-2 et 9, en sorte que le ruban est enterré dans la couche 5-1. La couche 5-2, située immédiatement au-dessus de la couche 5-1, est plus fortement dopée p que la couche 5-1 de façon à améliorer le contact avec la couche métallique de contact 6, par exemple en AuPt, qui est déposée ensuite.

L'effet de confinement électrique peut être augmenté en réalisant un bombardement ionique avec des protons H+ de parties de la couche 5 situées de part et d'autre du mésa du ruban 4 et non adjacentes à ce mésa. Les parties bombardées référencées 5-3 sur la partie C de la figure 2 sont ainsi rendues non conductrices. On limite ainsi les fuites de courant.

### Brève description de l'invention.

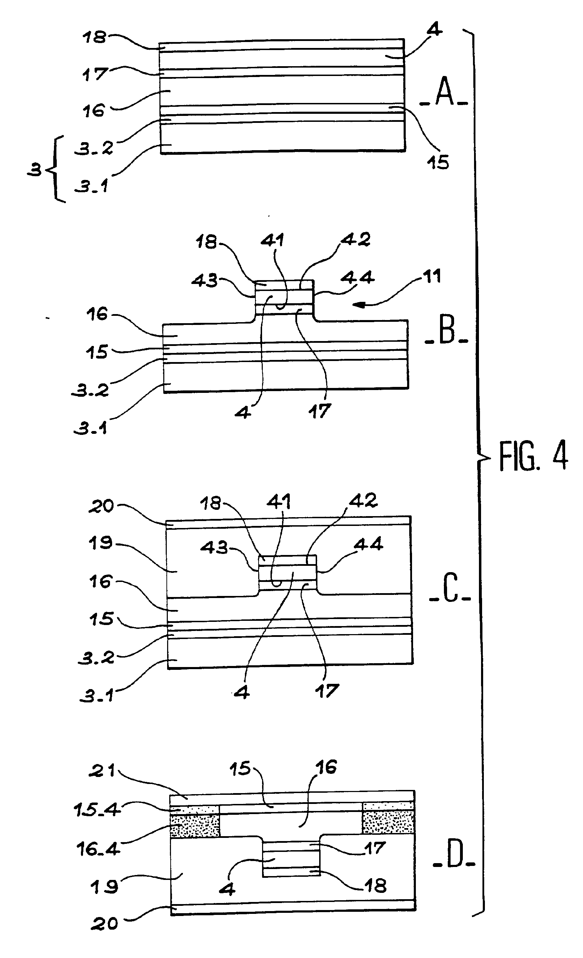

Le laser BRS à ruban enterré est considéré comme l'une des plus simples hétéro structures laser à ruban enterré. Cependant comme le confinement de courant des lasers BRS est obtenu par une jonction p-n polarisée de façon directe les fuites de courant dépendent fortement du niveau de dopage P et de la valeur du courant injecté, comme représenté figure 3. Cette figure représente des courbes indiquant le pourcentage de courant de fuite en ordonnée par rapport au courant de polarisation en abscisse pour différents niveaux de dopage p de la couche 5 en InP dopée p, dans laquelle le ruban 4 est enterré. Les valeurs de dopage p sont indiquées sur chacune des courbes. Le niveau de dopage n du ruban 4 est lui habituellement établi entre 10¹⁸ et 2 10¹⁸ par cm³. L'observation de ces courbes, en particulier celle dont le dopage p est de 5.10¹⁸ suggère qu'un niveau élevé de dopage p est de nature à réduire le courant de fuite, en particulier lorsque le courant de polarisation est élevé.

Par ailleurs il est connu que l'incorporation d'un haut niveau d'impuretés p, par exemple Zn, dans la couche 5 de InP pendant la seconde croissance épitaxiale conduit à une diffusion de ces impuretés, en particulier dans la couche adjacente formant la couche active laser 4 du dispositif. Les impuretés ainsi introduites dans la couche active 4 forment des sites de recombinaison non radiatifs et il en résulte une dégradation des performances du laser.

De plus les concentrations d'impuretés, par exemple Zn, lors de leur incorporation dans la couche InP sont variables en fonction des conditions d'orientation des parois du substrat. Ainsi pour les mêmes conditions de croissance, la concentration de Zn dans InP selon l'orientation <111> peut varier entre 7 fois plus haute et 10 fois plus basse par rapport à l'orientation <100>. On sait aussi, comme indiqué plus haut, que les parois 43, 44 du ruban d'un BRS ne sont pas planes et qu'elles sont obtenues par gravure. Ces parois peuvent être considérées comme constituées par un ensemble de facettes adjacentes les unes aux autres, les orientations de ces facettes étant différentes les unes des autres. Il en résulte qu'on peut s'attendre à ce que lors de la croissance épitaxiale au dessus des parois 43, 44 la concentration en Zn varie dans de fortes proportions le long de ces parois. Il résulte des explications ci-dessus que même si l'on vise des concentrations de Zn relativement faibles, ces concentrations pourront être localement très fortes le long des parois 43, 44 conduisant ainsi à des diffusions de Zn dans la couche active 4. Les caractéristiques du laser incluant notamment le gain, les pertes optiques, le courant de fuite, la température caractéristique du dispositif et les performances dynamiques s'en trouvent ainsi fortement dégradées et ce d'autant plus que la largeur du ruban est faible.

L'inventeur a remarqué que pendant la croissance d'une couche InP adjacente à la couche active, la diffusion vers la couche active d'impuretés de type n telles que Si présentes dans une couche InP dopée n est moins importante que la diffusion des impuretés de type p telles que Zn présente dans une couche InP dopée p.

Afin de réduire la diffusion du Zn dans la couche active, selon un premier mode de réalisation de l'invention on introduit une fine couche d'un matériau par exemple InP ou InGaAsP dopé n, entre la couche active 4 et une couche dopée p. De la sorte le ruban 4 a ses faces latérales inférieure et supérieure au contact d'une couche n, cette couche n empêchant les impuretés de type p de diffuser dans la couche 4 au travers des faces supérieures et inférieure de cette couche 4. Des lasers à large contact fabriqués de cette façon ont eu des caractéristiques, par exemple le rendement quantique, qui en sont améliorées notamment au plus bas niveau de courant de seuil, et ceci avec une bonne reproductibilité. Ainsi dans les dispositifs laser à larges contacts l'addition d'une fine couche dopée n à la structure de base s'est révélée efficace et la plupart du temps reproductible pour réduire la diffusion du Zn dans la couche active au travers de l'orientation 100 . Cependant les lasers BRS à ruban avec confinement de courant par jonction polarisée de façon directe continuent malgré la présence d'une telle fine couche de séparation à révéler des performances médiocres et une reproductibilité faible.

Dans le cas des structures BRS l'amélioration apportée par l'emploi de cette technique est moindre en raison du procédé de fabrication de ces structures. Ce procédé inclut, comme cela a été vu plus haut, une délimitation et une réalisation par gravure d'un mésa 11 étroit suivi par la croissance d'une couche InP-p de confinement de courant qui sert en même temps de confinement optique. Il en résulte que les parois latérales 43, 44 du mésa 11 ne sont pas couvertes par une couche dopée n. L'inventeur a supposé que l'inefficacité relative, dans le cas de la structure BRS, de la fine couche de matériau dopé n interposée entre la couche active et la couche p d'enterrement du ruban, provient du fait que Zn continue à diffuser au travers de ces parois 43, 44 non protégées, provoquant les inconvénients signalés plus haut. C'est pourquoi selon une seconde modalité de réalisation, l'invention vise un laser BRS et un procédé de fabrication d'un laser BRS dans lequel la couche active est en outre protégée des diffusions d'impuretés de type p, provenant de toutes les couches adjacentes à l'une des parois du ruban c'est à dire non seulement les parois supérieure et inférieure du ruban mais aussi les parois latérales joignant la paroi supérieure à la paroi inférieure. De la sorte on obtient un laser BRS amélioré présentant toute les qualités que l'on reconnaît habituellement au laser BRS, mais de plus capable d'émettre un rayonnement laser plus puissant grâce à un courant de polarisation important, et ceci sans courant de fuite excessif, provoquant les défauts signalés plus haut.

En conséquence selon ce mode de réalisation de l'invention au lieu de commencer à faire croître une couche de confinement InP n comme dans l'art antérieur, on fait débuter la croissance par une couche de confinement. On fait croître une fine couche d'InP dopée n, immédiatement avant de faire croître la couche active en sorte que la face inférieure de la couche active est adjacente à la fine couche dopée n. Par fine on entend inférieure à environ 1 µm et de préférence de l'ordre de 50 nanomètres.

On fait ensuite croître la couche active. La couche active est ainsi prise en sandwich entre deux couches dopées n et n'a été à aucun moment au contact d'une couche dopée p. Ensuite après délimitation par gravure du mésa comportant le ruban, une seconde croissance d'une couche de confinement InP-n est faite. De la sorte les parois latérales 43, 44 sont entourées par des matériaux dopés n au lieu d'être entourées par des matériaux dopés p par exemple avec Zn. On évite ainsi la diffusion de Zn dans la couche active au travers de toutes les parois du ruban.
- Ainsi, l'invention est relative à un procédé de fabrication d'un ensemble de puces laser à semi conducteur à ruban enterré. Ce procédé comporte les étapes ci-après :former une couche de confinement dopée p,
- former une fine couche dopée n
- former la couche active laser,
- graver localement ladite couche active pour la former en ruban,
- enterrer le dit ruban dans une couche dopée n, en sorte que les faces latérales du ruban sont toutes adjacentes à une couche dopée n.

On supprime ainsi les diffusions de dopant p dans la couche active puisque, à aucun moment de la fabrication, la couche active n'est au contact d'une couche dopée p.

Le procédé selon l'invention se décline selon deux variantes de réalisation. Dans une première variante réalisée sur une plaquette substrat dont au moins une couche supérieure est réalisée dans un matériau dopé p, après l'étape d'enterrement du mésa dans la couche de confinement dopée n, on dépose au dessus de cette couche d'enterrement dopée n une couche de métallisation.

On retourne ensuite la plaquette initiale sur une seconde plaquette en sorte que la couche de métallisation déposée se trouve au contact de la seconde plaquette,

On ôte le substrat formant la plaquette initiale jusqu'à atteindre la couche de matériau dopée p sur laquelle on avait fait croître la couche de confinement dopée n enterrant le mésa.

On dépose enfin une couche de métallisation sur ladite couche de matériau dopée p, qui du fait du retournement et du retrait du substrat se trouve maintenant être la couche supérieure. De préférence on procède avant ce dépôt de la couche de métallisation, au dépôt d'une couche intermédiaire de contact très fortement dopée p qui assure un meilleur contact ohmique.

Selon une seconde variante de réalisation après l'étape d'enterrement du mésa dans la couche de confinement dopée n, on réduit par gravure de part et d'autre du mésa, la largeur de la couche d'enterrement, et après masquage de la surface supérieure restante de la couche d'enterrement, on dépose latéralement de part et d'autre du mésa, de façon sélective, une couche d'isolement.

La couche supérieure de métallisation est déposée ensuite après retrait du masque.

Le laser à ruban enterré selon l'invention est caractérisé en ce que deux de ses faces latérales, les surfaces inférieure et supérieure sont adjacentes à des couches dopées n. Evidemment, comme expliqué plus haut, il est hautement préférable que les quatre faces latérales, c'est à dire non seulement les faces supérieure et inférieure mais en outre les deux faces joignant les faces supérieure et inférieure du ruban soient adjacentes à une couche dopée n.

### Brève description des dessins.

Des exemples de réalisation de l'invention seront maintenant décrits en regard des dessins annexés dans lesquels :
- la figure 1 déjà décrite représente un schéma de principe d'un laser à ruban enterré faisant apparaître les différentes couches et le ruban ;
- la figure 2 déjà décrite représente des coupes transversales de l'état d'avancement de la fabrication d'un laser à ruban enterré. Elle comporte les parties A, B, C ;
- la figure 3 déjà décrite représente un ensemble de courbes représentant pour différentes concentrations de dopage p le pourcentage des courants de fuite en fonction du courant de polarisation ;
- la figure 4 représente différents stades de la fabrication d'un laser à ruban réalisé selon un premier mode de réalisation du procédé de l'invention. Elle comporte les parties A, B, C et D.
- la figure 5 représente différents stades de la fabrication d'un laser à ruban réalisé selon un second mode de réalisation du procédé de l'invention. Elle comporte les parties c', c'', c'''.

### Description de modes de réalisation

Comme connu dans l'art la fabrication part d'une plaquette substrat en matériau III-V par exemple en InP, dopé indifféremment n ou p sur laquelle on dépose les couches successives. Sur cette plaquette, un grand nombre de puces sont réalisées qu'il faudra ensuite séparer. Au niveau de la description de la figure 4 qui va suivre on s'intéresse à une seule puce. La fabrication est effectuée comme suit :
sur un substrat III-V référencé 3-1 en InP, on réalise
   a) une première croissance épitaxiale d'une couche écran 3-2 (buffer) en InP non dopée d'environ 0,5 µm d'épaisseur. On réalise ensuite une croissance épitaxiale d'une couche 15 de contact d'environ 0,3 µm d'épaisseur de p+ InGaAs. Il sera vu plus loin que cette couche est destinée à recevoir sur sa face adjacente à ce stade de la fabrication à la couche 3-2, une couche métallique pour un contact p par exemple en AuPt.
   b) On procède ensuite à la croissance épitaxiale d'une couche 16 de confinement d'environ 3 µm d'épaisseur de p InP, avec une concentration de dopage de 1,5 à 2.10¹⁸/cm³.
   c) Vient ensuite la fine couche 17 dopée n par exemple avec Si d'environ 50 nm d'épaisseur de InGaAsP.
   d) On fait croître ensuite la couche active 4 et
   e) enfin une fine couche 18 de InP non dopée d'environ 0,1 µm d'épaisseur. Cette dernière couche est destinée à protéger la couche active 4 au cours de la fabrication.

Après les opérations qui viennent d'être décrites ci-dessus le dispositif a la forme représentée en partie A de la figure 4,
2) la fabrication se poursuit ensuite par
f) une gravure destinée à assurer la délimitation du mésa 11 portant le ruban 4. La gravure, par exemple sèche, est effectuée jusqu'à atteindre la couche 16 de p InP.

A la fin de l'étape de gravure le dispositif a la forme représentée en partie B de la figure 4. Les couches inférieures 3-1, 3-2 et 15 ne sont pas modifiées. Une partie de la couche 16 émerge au dessus du reste de la couche 16. Cette partie émergente de la couche 16 supporte le reste de la couche 17, le reste de la couche 4 formant le ruban 4 et le reste de la couche 18. La partie émergente de la couche 16 et les restes des couches 17, 4, 18 forment ensemble le mésa 11,
g) on réalise alors une seconde croissance épitaxiale d'une couche 19 de confinement de 3 µm d'épaisseur InP dopé n avec une concentration de dopage, par exemple de 2.10¹⁸/cm³.
h) On dépose ensuite une couche 20 de métallisation n, par exemple en TiAu. A la fin de cette phase de la fabrication le dispositif a la forme représentée en partie C de la figure 4.
i) On réalise ensuite au niveau de la plaquette des rainures en V pour préparer le tracé de séparation des puces.
j) Après amincissement du substrat 3 à une épaisseur d'environ 120 µm par polissage mécanique ou chimique, on retourne la plaquette initiale ainsi réalisée sur une seconde plaquette par exemple en Si sur laquelle des plots de métallisation ont déjà été tracés.
k) Le reste de l'épaisseur du substrat 3 en InP, qui du fait du retournement, se trouve maintenant sur le dessus, est alors ôté, par des procédés de gravure tout d'abord rapide, puis plus lente pour ôter la dernière partie. La couche de contact 15 sert aussi de couche d'arrêt de cette gravure.
l) Une couche 21 de métallisation p standard par exemple en AuPt est déposée. La couche 3 formée des couches 3-1 et 3-2 ayant été dégagée la couche de métallisation 21 vient se déposer au dessus de la couche de contact 15.

Des implantations en protons dans des parties latérales extérieures 15-4 et 16-4 des couches dopées p 15 et 16 respectivement peuvent ensuite être effectuées pour limiter les courants de fuite.

Le produit final a la forme représentée en partie D de la figure 4. Le ruban 4 est enterré dans une couche 19 dopée n. Il est séparé de la couche 16 dopée p par une couche fine 17 dopée n en sorte qu'à aucun moment il n'y a eu migration de dopant p, par exemple Zn vers la couche 4 formant le ruban.

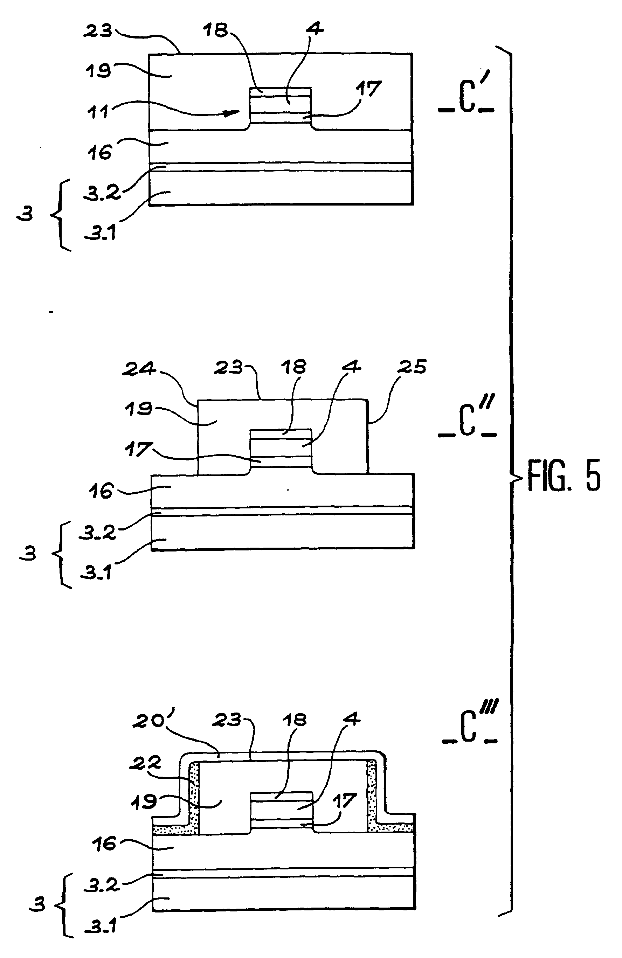

Selon une variante de réalisation dans laquelle le ruban 4 est isolé électriquement du reste de la structure de façon différente, on interpose des couches 22 d'un matériau diélectrique dans des conditions qui vont maintenant être commentées en liaison avec la figure 5. Cette figure comporte les parties C', C'' et C'''.

Pour la réalisation de cette variante les étapes b) à g) décrites ci-dessus restent les mêmes. La variation par rapport au premier mode de réalisation commence alors que la fabrication du laser à ruban enterré se trouve dans l'état représenté par la partie C de la figure 4 avec les deux différences ci-après. La couche de contact dopée p 15 n'est pas présente et la couche de métallisation 20 n'a pas été déposée. On se trouve donc dans l'état représenté par la partie C' de la figure 5.

Le dispositif comporte à cette étape représentée par la partie C', du bas de la figure vers le haut, le substrat 3 dopé p, réparti en deux épaisseurs 3-1 et 3-2, la couche 16 de confinement en p InP, la fine couche 17 en matériau dopé n, le ruban 4, et enfin la couche de protection 18. Le ruban 4 se trouve dans un mésa 11 formé par une partie de la couche 16 subsistant après la gravure de délimitation du mésa et de ce qui reste des couches 17, 4, et 18 après cette gravure de délimitation du mésa 11. Le mésa 11 est entouré sur 3 de ses faces latérales, 42-44, par la couche 19 en matériau InP dopé n et sur sa quatrième face latérale 41 par la fine couche 17 en matériau dopé n. L'état représenté en C' est identique à l'état représenté en C figure 4, à l'exception de la couche de métallisation 20, qui n'est pas présente, et de la couche 15 en InGaAsP dopée p+ qui n'est plus nécessaire. De plus dans ce mode de réalisation on part d'un substrat dopé p.

A partir de cet état on réalise,
g1) de préférence de façon symétrique par rapport au mésa 11, une gravure latérale de la couche 19, pour enlever des parties se trouvant de part et d'autre du mésa 11 mais non adjacentes au mésa 11. Ainsi après cette gravure de la couche 19 d'enterrement du mésa 11, le mésa 11 est toujours entouré par sa couche d'enterrement 19, mais la largeur de cette couche à été réduite, par exemple à environ 4 fois la largeur du ruban 4. Pour fixer un ordre de grandeur, si le ruban 4 a une largeur d'environ 1,5 µm, le reste de la couche 19 pourra avoir une largeur d'environ 6 µm.

Le dispositif a, après la gravure de la couche d'enterrement 19, la forme représentée sur la partie C'' de la figure 5. La couche 19 comporte une surface supérieure 23 et deux surfaces 24, 25 sensiblement perpendiculaires au plan des couches,
g2) un dépôt sélectif latéral d'une couche 22 d'un matériau diélectrique, par exemple en Si₃N₄ ou en SiO₂ en masquant la surface supérieure 23 de la couche d'enterrement 19 gravée. La couche 22 est déposée en une seule fois. Du fait qu'elle se répartit de part et d'autre du mésa 11, lorsqu'elle est déposée elle est constituée de deux parties séparées l'une de l'autre par la largeur de la couche d'enterrement 19 gravée. Chacune des parties de couche 22 vient ainsi recouvrir les surfaces 24, 25 de la couche 19. Ainsi les couches 22 sont sensiblement perpendiculaires au plan des faces supérieure ou inférieure du ruban 4, et séparées l'une de l'autre par la largeur de la couche 19 gravée, c'est à dire comme expliqué plus haut environ 4 fois la largeur du ruban 4. De préférence, les parties de couche 22 s'étendent aussi de façon continue à la couche 16 qu'elles recouvrent de part et d'autre du mésa 11.
g3) On démasque la surface supérieure 23 de la couche 19,
h') on réalise ensuite la couche métallique de contact n 20', par exemple en TiAu de façon à ce qu'elle recouvre au moins la partie supérieure 23 de la couche 19, mais de préférence afin qu'elle recouvre cette partie supérieure 23 et la couche d'isolement électrique 22. L'état du dispositif réalisé selon ce mode préféré de dépôt de la couche de contact 20' et immédiatement après le dépôt de cette couche 20', est représenté en partie C''' de la figure 5.

La fabrication se poursuit ensuite comme dans le mode précédemment décrit de réalisation du procédé selon l'invention à l'exception des étapes j) à k).

L'étape j est remplacée par une étape j' dans laquelle le substrat 3 est aminci à une épaisseur d'environ 120 µm par polissage mécanique ou chimique. Un dépôt métallique par exemple en PtTiAu est ensuite effectué avant de procéder au clivage de séparation des différentes puces.

Selon cette variante de réalisation il n'est pas possible d'effectuer une implantation protonique dans du matériau InP dopé n. L'amélioration du confinement électrique est alors obtenue grâce à la couche 22 d'isolement.

## Revendications

1. Procédé de fabrication d'une structure laser en semi conducteur à ruban enterré **caractérisé en ce qu'**il comporte notamment les étapes ci-après :
(b) former une couche (16) de confinement dopée p au dessus d'un substrat en matériau III-V,
(c) former une fine couche (17) dopée n,
(d) former une couche (4) active,
(f) graver localement ladite couche (4) active, la fine couche (17) dopée n, et une partie de l'épaisseur de la couche (16) de confinement dopée p pour former un mésa (11), ce mésa (11) comportant le ruban (4),
(g) enterrer le dit ruban (4) dans une couche (19) dopée n, en sorte que les faces latérales (41-44) du ruban (4) sont toutes adjacentes à une couche (17, 19) dopée n.

2. Procédé selon la revendication 1 effectué sur une plaquette en matériau III V dopé p **caractérisé en ce qu'**il comporte en outre après l'étape (g) d'enterrement du ruban (4) dans la couche (19) d'enterrement, des étapes,
(g1) de réalisation d'une gravure de réduction de la largeur de cette couche (19), pour enlever des parties se trouvant de part et d'autre du mésa (11) mais non adjacentes à ce mésa (11) en sorte qu'après cette gravure le ruban (4) est toujours enterré dans la couche d'enterrement (19), la couche 19 gravée ayant une largeur réduite, une surface supérieure (23) et des surfaces (24, 25) sensiblement perpendiculaires au plan des faces (41, 42) supérieure ou inférieure du ruban (4)
(g2) de réalisation d'un dépôt d'une couche (22) d'isolement en matériau diélectrique en masquant la surface supérieure (23) de la couche (19) d'enterrement de largeur réduite, en sorte que cette couche (22) d'isolement recouvre les surfaces latérales (24, 25) de cette couche (19) d'enterrement et des parties de la couche (16) de confinement dopée p situées de part et d'autre du mésa (11).

3. Procédé selon l'une des revendications 1 ou 2 **caractérisé en ce qu'**il comporte en outre, après l'étape d) de formation de la couche (4) active laser une étape,
(e) de réalisation d'une fine couche 18 de protection de la couche (4) active laser.

4. Procédé selon la revendication 1 **caractérisé en ce qu'**il comporte en outre, après l'étape g) de seconde croissance de la couche (19) de confinement une étape
(h) de déposition au dessus de cette couche (19) de confinement, d'une couche de métallisation (20).

5. Procédé selon la revendication 2 **caractérisé en ce qu'**il comporte en outre après l'étape g2) de dépôt d'une couche (22) d'isolement en matériau diélectrique, une étape
(h') de déposition au dessus de la couche (19) de confinement gravée, d'une couche de métallisation (20').

6. Procédé de fabrication d'une structure laser à semi conducteur selon la revendication 4 **caractérisé en ce qu'**il comporte en outre
- avant l'étape (b) de dépôt de la couche (16) de confinement au dessus du substrat en matériau III-V une étape (a) selon laquelle
(a) on fait croître par épitaxie une couche (15) de contact dopée p, et
- après l'étape h) de dépôt de la couche (20) de métallisation, les étapes
(k) de retournement sur une seconde plaquette, et de soustraction du substrat (3) (l) de dépôt d'une couche (21) de métallisation par dessus la couche (15) de contact.

7. Procédé de fabrication d'une structure laser à semi conducteur selon la revendication 6 **caractérisé en ce qu'**il comporte en outre une étape d'implantation en protons dans des parties latérales (15-4, 16-4) extérieures de couches ((15, 16) dopées p.

8. Laser à ruban (4) enterré comportant un ruban (4) formant partie d'un mésa (11) enterré, le ruban (4) ayant quatre faces latérales (41-44) une face supérieure (42), une face inférieure (41), et deux faces de jonction des faces supérieure et inférieure **caractérisé en ce que** les faces latérales (41-42) inférieure et supérieure du ruban (4) sont adjacentes à une couche (17, 19) dopée n.

9. Laser à ruban (4) enterré selon la revendication 8 **caractérisé en ce que** en outre les faces latérales de jonction des faces supérieure et inférieure sont également adjacente à une couche (19) dopée n.

10. Laser à ruban (4) enterré selon l'une des revendications 8 ou 9 **caractérisé en ce que** une couche (17) dopée n séparant le ruban (4) d'une couche (16) dopée p a une épaisseur inférieure à 1 µm.

11. Laser à ruban (4) enterré selon l'une des revendications 8 ou 9 **caractérisé en ce qu'**il comporte de part et d'autre du mésa (11) incorporant le ruban (4), des parties d'une couche (22) de matériau diélectrique, chacune de ces parties de couche (22) étant perpendiculaire aux plans des faces supérieure et inférieure du ruban (4).

12. Laser à ruban (4) enterré selon la revendication 11 **caractérisé en ce que** les parties de couche (22) de matériau diélectrique situées de part et d'autre du mésa (11) incorporant le ruban (4), sont séparées l'une de l'autre par une distance sensiblement égale à quatre fois la largeur du ruban (4).
